# FASCICULE DE BREVET EUROPEEN

(11) **EP 0 645 714 B1**
(45) Date de publication et mention de la délivrance du brevet: **22.01.1997**
(21) Numéro de dépôt: 94402091.6
(22) Date de dépôt: 20.09.1994
(51) Int. Cl.: G06F 11/20

(54) **Circuit de redondance dynamique pour mémoire en circuit intégré**
Dynamische Redundanzschaltung für integrierten Speicher
Dynamic redundancy circuit for integrated circuit memory

(30) Priorité: 20.09.1993 FR 9311169
(43) Date de publication de la demande: 29.03.1995
(73) Titulaire: SGS-THOMSON MICROELECTRONICS S.A., 94250 Gentilly (FR)
(72) Inventeur: Tailliet, Francois, F-75116 Paris (FR)
(74) Mandataire: Schmit, Christian Norbert Marie

(56) Documents cités:
- EP-A- 0 392 895
- EP-A- 0 448 970
- GB-A- 2 136 992
- US-A- 4 051 354
- US-A- 4 733 394

## Description

La présente invention a pour objet un circuit de redondance dynamique pour mémoire en circuit intégré. Elle est utilisable en particulier dans le domaine des mémoires non volatiles, notamment celui des mémoires de type EEPROM. Elle est aussi utilisée dans le domaine des microcontroleurs: microprocesseurs munis sur le même circuit intégré d'une mémoire non volatile de programmes ou de données. Elle a pour objet d'en prolonger l'utilisation.

En effet, l'utilisation de ce type de mémoire est actuellement limité par le nombre d'opérations d'écriture et d'effacement qu'elles sont susceptibles de supporter. Une cellule mémoire de ce type comporte dans son principe un transistor à grille flottante qui est chargé ou déchargé de charges électriques, selon l'état binaire à mémoriser. Les phénomènes de fuite de ces charges diélectriques et leur maintien prisonnières dans une région isolante située entre le canal de conduction du transistor à grille flottante et la grille flottante, conduit à une programmation ou à un effacement de plus en plus difficile avec le vieillissement, la détérioration ou la mise hors d'usage de la cellule. Bien que la technologie moderne permette un nombre important de cycles, par exemple cent mille, cette performance est encore insuffisante dans certains cas. En pratique dès qu'une seule des cellules mémoires d'un tel circuit est atteinte, tout le circuit doit être mis de côté. Un des buts de l'invention est de proposer un circuit qui permette, en cours d'utilisation, le remplacement d'une cellule défectueuse par une cellule en bon état redondante.

On connaît par ailleurs des circuits de redondance et leur mise en oeuvre. Ces circuits sont principalement utilisés au moment du test des circuits intégrés mémoires, à l'issue de leur fabrication. Dans ce but, quand une mémoire est fabriquée, on teste une à une chacune de ses cellules mémoires. Quand on détecte une cellule mémoire en mauvais état, il est par exemple impossible de la programmer ou de l'effacer, ou encore elle est en court circuit ou autre, on provoque la neutralisation de cette cellule mémoire, et on la remplace par une cellule mémoire supplémentaire. Ce remplacement consiste à remplacer l'adresse de la cellule en mauvais état par l'adresse de la cellule de remplacement. Ceci est obtenu, au moment du test de la cellule, par une opération spécifique comportant dans son principe l'ouverture de certains interrupteurs d'adressage du circuit intégré et la fermeture d'autres interrupteurs en relation avec les premiers. Ces interrupteurs peuvent en pratique être constitués soit par des fusibles, soit même par des cellules de type EEPROM elles-mêmes. L'ouverture et la fermeture de ces interrupteurs, le claquage des fusibles correspondant ou la programmation ou l'effacement des cellules EEPROM destinées à cet effet sont provoqués par un circuit extérieur au circuit intégré de la mémoire, et pilotés par ailleurs par un logiciel contenu dans la machine de test. Ce logiciel prend en compte la structure particulière de la mémoire et de ses circuits de redondance.

En cours d'utilisation, le principe de la programmation de l'effacement d'une cellule mémoire est le suivant. Lorsqu'une cellule doit être programmée ou effacée, un micro-programme est exécuté par un automate inclus dans la mémoire. Il a pour but de précharger en tension de programmation ou d'effacement des connexions d'accès à la cellule puis de sélectionner par adressage la cellule à modifier. Après cette opération, dans le cas des cellules EEPROM, la cellule à modifier n'est pas vérifiée pour constater son état. La détection de ce que la mémoire en circuit intégré EEPROM doit être écartée parce que son fonctionnement n'est plus fiable n'est pas réalisée en pratique.

Dans le cas des cellules EPROM, par contre, il est connu de regarder si l'état obtenu à l'issue de la modification est conforme à l'état modifié à obtenir. Eventuellement, on réitère l'opération de modification, écriture/effacement, un certain nombre de fois. Par ailleurs on compte le nombre de tentatives. Lorsque ce nombre de tentatives dépasse un nombre fixé à l'avance, par exemple cinq ou six tentatives, un automate de la mémoire est capable d'émettre un signal d'erreur pour informer que la cellule mémoire concernée n'est plus en état de fonctionner correctement.

Dans l'invention, par un circuit de redondance dynamique, on va interpréter un tel signal d'erreur et l'adresse de la cellule défectueuse pour, premièrement, dérouter l'adresse de cette cellule défectueuse sur une adresse d'une cellule de redondance et, deuxièmement, programmer ou effacer en correspondance la cellule de redondance en lieu et place de la cellule défectueuse. Le fonctionnement est alors transparent pour l'utilisateur.

Le résultat le plus important est alors qu'au lieu de disposer d'une mémoire susceptible de cent mille cycles effacement/écriture on obtient maintenant une mémoire susceptible de plusieurs millions de cycles effacement/écriture. En effet il apparaît statistiquement que ce sont toujours les mêmes cellules qui sont sollicitées le plus souvent. Le fait de pouvoir les remplacer lorsqu'elle sont défectueuses augmente considérablement la durée de vie de la mémoire en circuit intégré.

Telle que revendiquée, l'invention concerne donc une mémoire en circuit intégré non volatile, programmable et effaçable électriquement, comportant des mots mémoires, chaque cellule mémoire d'un mot mémoire étant munie d'un transistor à grille flottante et un circuit logique programmable dynamiquement muni :
- d'une mémoire auxiliaire non volatile pour mémoriser des adresses de mots mémoires défectueux, et
- d'un circuit de réadressage pour sélectionner, en remplacement, un autre mot de cette mémoire.

Selon l'invention, le circuit logique programmable dynamiquement est également muni d'un circuit de comparaison d'une adresse de sélection d'un mot mémoire à une adresse mémorisée dans la mémoire auxiliaire. Le circuit de comparaison comporte, en sortie, un jeu de portes OU connectées, en entrée, à un jeu de portes ET, elles mêmes connectées, en entrée, à un comparateur, la mémoire auxiliaire étant reliée à ce comparateur, ledit comparateur étant destiné à comparer simultanément ladite adresse de sélection d'un mot mémoire aux adresses de mots mémoires défectueux, ledit jeu de portes OU délivrant pour ledit circuit de réadressage un signal de commande permettant d'invalider le décodage des bits d'adresse correspondant aux mots mémoires défectueux, ainsi qu'un nombre prédéterminé de bits d'adresse de substitution.

L'invention sera mieux comprise à la lecture de la -description qui suit et à l'examen des figures qui l'accompagnent. Celles-ci ne sont données qu'à titre indicatif et nullement limitatif de l'invention. Les figures montrent :
- Figure 1 : une représentation schématique d'une mémoire en circuit intégré munie d'un circuit de redondance dynamique selon l'invention ;
- Figure 2 : la représentation d'une mémoire auxiliaire utilisée pour mémoriser, au fur et à mesure de leur apparition, les adresses de cellules défectueuses à remplacer ;
- Figure 3 : un circuit logique programmable capable de produire des signaux d'adresse de cellules de remplacement en lieu et place de signaux d'adresse de cellules défectueuses ;
- Figures 4a et 4b : un circuit de sélection d'adresse parmi les adresses de cellules défectueuses pour sélectionner une bonne adresse de remplacement.

Un circuit de déroutage est par exemple connu par la demande de brevet PCT N° WO 90/812364. Dans cette demande de brevet, pour réparer une mémoire on interpose un codeur d'adresse pour que les informations à stocker dans la mémoire soient stockées dans des régions mémoires de remplacement désignées par le codeur d'adresse plutôt que dans des régions défectueuses. Un même principe est également mis en oeuvre dans le brevet US-A-4 310 901. Dans aucun de ces enseignements cependant, il n'est prévu un circuit automatique et intégré de déroutage d'adresse comme dans la présente invention, c'est à dire mis en service au fur et à mesure du besoin.

L'invention concerne plus particulièrement des EEPROM à accès série. En effet, pour ce type de mémoire, le problème des temps d'accès est moins contraignant et par conséquent on a plus facilement la possibilité de faire un déroutage d'adresse. Cependant, l'invention est aussi applicable, comme on le verra, aux mémoires EEPROM à accès parallèle. Le circuit est simplement un peu plus compliqué dans ce cas.

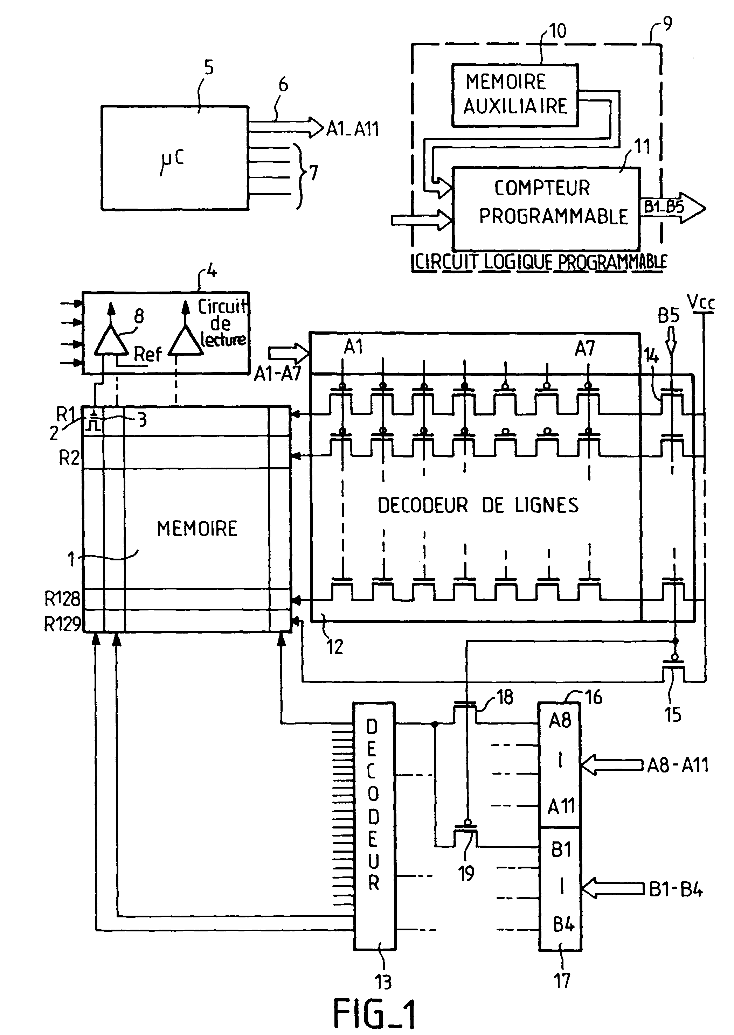

La figure 1 montre une mémoire en circuit intégré non volatile munie, selon l'invention, d'un circuit de redondance dynamique. La mémoire proprement dite 1 comporte un certain nombre de mots mémoires, dans un exemple chiffré, utilisé tout au cours de cette description uniquement pour des raisons de simplicité d'explication, elle comporte 2048 mots mémoires. Chaque mot mémoire peut avoir 8, 16, 32 ou n bits. Chaque cellule mémoire, correspondant à un bit, comporte un transistor 2 à grille flottante 3. La mémoire comporte un circuit d'effacement/écriture 4 et est pilotée par un automate 5 délivrant des signaux de commande 7. Des signaux d'adresse 6 sont délivrés par des décodeurs d'adresse. Ces éléments sont de type connu, notamment le circuit de lecture écriture comporte des amplificateurs 8 pour la lecture, ainsi que des circuits pour effacer ou programmer une cellule, donc soumettre une ligne de bit qui conduit à cette cellule à une tension correspondante et provoquer effectivement l'application de cette tension correspondante à cette cellule sous l'effet d'un signal d'adresse sélectionnant la cellule concernée.

Dans l'invention le circuit de redondance dynamique comporte, dans un circuit logique programmable dynamiquement 9, une mémoire auxiliaire 10 de type non volatile pour mémoriser des adresses de cellules ou de mots mémoires défectueux parce que leur qualité de mémorisation est insuffisante. Le circuit 9 comporte également un circuit de comparaison 11 pour comparer une adresse d'un mot mémoire sélectionné à chacune des adresses d'une liste d'adresses mémorisées dans la mémoire auxiliaire 10. Le circuit 9 est capable de produire des signaux de réadressage en fonction de cette comparaison. Ces signaux de réadressage sont appliqués à un circuit de réadressage pour sélectionner en remplacement une autre cellule ou un autre mot de la mémoire.

Dans l'exemple où la mémoire comporte 2048 mots mémoires les adresses de ces mots mémoires sont exprimées en binaire sur onze bits. Ces onze bits sont appelés A1-A11. Ces onze bits sont appliqués sur deux décodeurs. Un premier décodeur 12, dit décodeur de ligne ou décodeur de rangée, reçoit les bits d'adresse A1 à A7. Un deuxième décodeur 13 dit décodeur de colonne, reçoit les bits d'adresse A8 à A11. Le principe de ces décodeurs est connu. Ceux-ci comportent, en cascade avec chaque ligne ou colonne sélectionnée, une batterie de transistors de type N formant une porte ET à autant d'entrées qu'il y a de transistors. Il y a de nombreuses variantes de réalisations de tels décodeurs. Sur ces entrées sont appliqués des signaux d'adresse, ou des signaux complémentaires, de façon à sélectionner une bonne ligne ou une bonne colonne à chaque fois. Par exemple le décodeur 12 comporte, sur une première rangée, une cascade de sept transistors de type N interposés entre la première rangée R1 de la mémoire et une alimentation V_{cc} du circuit. Lorsque les grilles de commande de ces transistors reçoivent un bit d'adresse, respectivement A0, A1,... A7, à 1, la ligne de mot de la première rangée R1 est portée à V_{cc}. Par opposition, à ce moment, la 128ème ligne de mots R128, qui est en cascade avec sept transistors également de type N recevant des signaux d'adresse complémentaires respectivement A0/, A1/, ... A7/, est déconnectée. De même le décodeur 13 reçoit les signaux d'adresse A8 à A11 et A8/ à A11/ et sélectionne une parmi seize lignes de bits (ou groupe de lignes de bits si la mémoire est organisée en mots de 8,16,32, bits).

Le principe de l'invention est de simplifier le plus possible la constitution des circuits de redondance. Dans ce but le circuit de réadressage comporte dans son principe, en cascade avec chacune des lignes de mots, un transistor supplémentaire tel que le transistor N 14 (ligne R1) recevant un signal B5 relatif à la détection ou non d'un adressage d'une cellule défectueuse de la mémoire 1. Le circuit logique programmable 9 produit ainsi des signaux d'adresse B1 à B4 de remplacement de l'adresse défectueuse ainsi qu'un signal supplémentaire B5 porté dans un exemple à l'état 1 (V_{cc}) lorsque aucune adresse défectueuse n'a été détectée, ou à l'état zéro dans le cas contraire. De ce fait, le transistor 14 autorise ou neutralise selon son état la sélection de la ligne R1. Plutôt que d'avoir un transistor 14 en face de chacune des lignes de mots en cascade avec ses sept transistors de décodage, il est possible d'avoir un seul transistor 14 interposé entre l'alimentation V_{cc} et l'ensemble de ces lignes.

Selon une variante particulièrement intéressante de l'invention, la mémoire 1 comporte une ligne supplémentaire utilisée en redondance: la 129ème ligne R129. Les cellules de cette 129ème ligne sont reliées au circuit d'effacement/écriture 4 de la même façon que les cellules des autres lignes. Les lignes de bit se prolongent simplement jusqu'à la ligne R129. La sélection de la ligne R129 est obtenue par la mise en conduction d'un transistor 15, ici de type P, de polarité inversée à celle du transistor 14. Le transistor 15 reçoit alors le même signal B5 sur sa grille. En variante le transistor 15 est de type N et reçoit un signal B5/ complémentaire du signal B5. Il est par ailleurs également relié à l'alimentation V_{cc}. Lorsque le signal B5 est nul, le transistor 15 est passant, il sélectionne la ligne R129 alors que toutes les 128 premières lignes sont neutralisées.

Les bits d'adresse A8 à A11 sont envoyés au décodeur 13 par l'intermédiaire de bascules de type bistable contenues dans un circuit 16. Ce circuit 16 comporte ainsi quatre sorties reliées à quatre entrées du décodeur 13 en relation avec chacun des quatre bits d'adresse à décoder. Le circuit de réadressage de l'invention comporte en outre un autre circuit 17, équivalent de bascules bistables pour stocker quatre bits d'adresse en remplacement des bits d'adresse A8 à A11 de l'adresse défectueuse préalablement sélectionnée. Les circuits 16 et 17 sont munis de circuit bistables constitués par exemple par un agencement de deux inverseurs (deux transistors) montés tête-bêche.

Le décodeur 13 possède quatre entrées mises en relation sélectivement avec quatre sorties des circuits 16 ou 17 selon que l'adresse sélectionnée est bonne ou mauvaise. Il est mis en relation avec ces circuits 16 ou 17 respectivement par des transistors 18 ou 19 de type N ou P recevant sur leur grille le signal B5. En variante les transistors 18 et 19 sont tous les deux de type N et reçoivent respectivement des signaux B5 et B5/. Les entrées correspondantes du décodeur 13 sont reliées aux sorties des circuits 16 ou 17 par les connexions drains et sources de ces transistors.

Dans l'exemple représenté sur la figure 1, une première entrée du décodeur 13 est mise en relation avec la première sortie du circuit 16 si le signal B5 vaut 1 et est émis en relation avec la première sortie du circuit 17 si le signal B5 vaut zéro. Le décodeur 13 ayant 4 entrées il y a quatre couples de transistors tel que 18-19 dans le circuit de réadressage.

Le circuit de réadressage de l'invention comporte donc ici, simplement, les transistors 14-15, les couples de transistors 18-19 et le circuit 17. On notera que ces transistors et ce circuit 17 sont équivalents à des transistors, ceux du décodeur 12, ou au circuit 16, déjà existants, de sorte que leur fabrication au moment de la constitution du circuit intégré ne nécessite pas d'opération de masquage ou d'implantation supplémentaire.

La sélection décrite ici est donc particulièrement simple en ce sens que le circuit de lecture/écriture/ effacement 4 et les décodeurs 12 et 13 sont communs à la mémoire 1 et à la partie redondante ce cette mémoire. Par ailleurs les décodeurs 12 et 13 sont très légèrement modifiés. Le fait d'avoir une ligne R129 de redondance permet sur le plan pratique d'éloigner les cellules de redondance, statistiquement, des cellules défectueuses. Ceci s'oppose à des solutions actuelles, dans lesquelles des cellules de redondance sont montées en parallèle, physiquement côte à côte avec des cellules à réparer. Quand une cellule a un vice, il est courant que la cellule immédiatement voisine a le même vice. Les solutions de ce type ne sont donc pas bonnes. Avec la ligne R129 éloignée, l'invention évite ce problème.

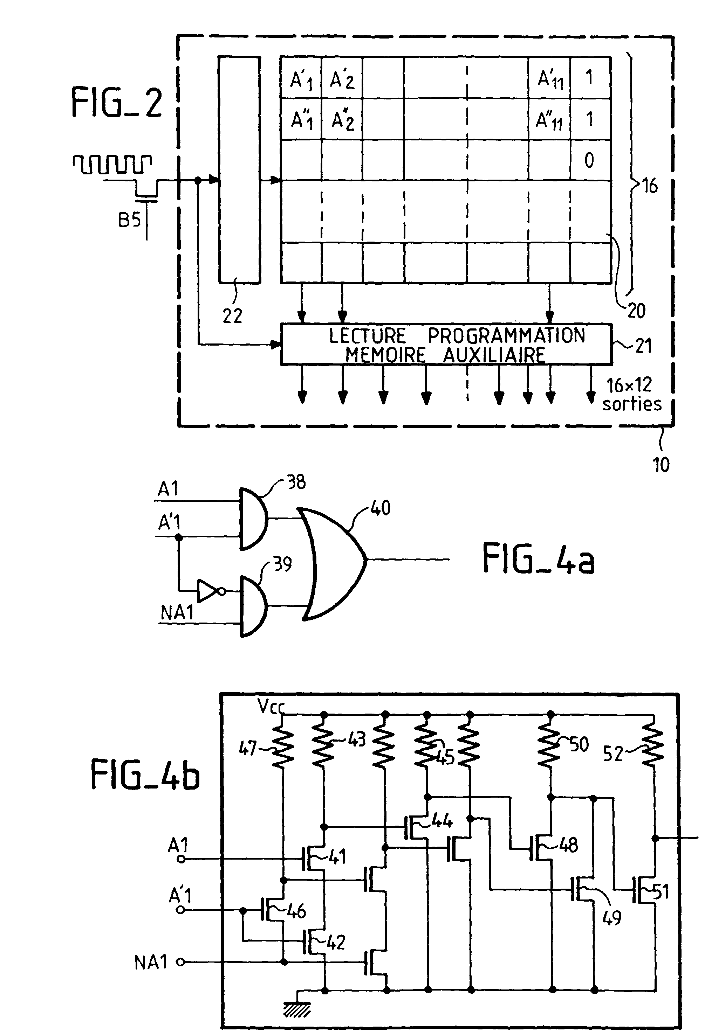

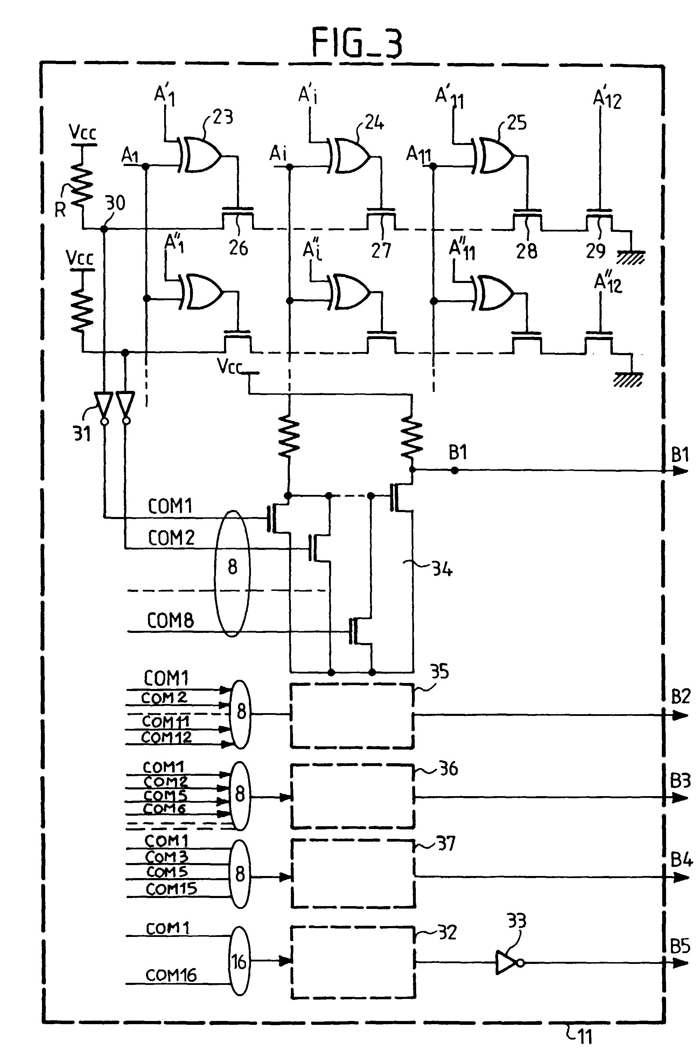

La figure 2 montre, avec la figure 3, le circuit logique programmable de l'invention. La figure 2 montre une mémoire auxiliaire, programmable. La figure 3 montre le circuit logique. Le principe est le suivant. Dans un exemple, la mémoire auxiliaire 10 comporte 16 mots pour enregistrer 16 adresses de cellules défectueuses (ou mots défectueux) dans la mémoire 1. Ces 16 adresses y sont chacune enregistrées sur 11 bits. Un douzième bit est associé à chaque adresse de 11 bits pour signaler que l'adresse stockée correspond effectivement à une adresse de cellules défectueuses ou au contraire que l'adresse stockée ne correspond à rien. Ceci est en particulier le cas lorsque, au sortir de fabrication, aucune des cellules mémoires de la mémoire 10 n'a encore été programmée. Dans ce cas, en bout de chacune des 16 lignes de mémorisation d'adresses dans la mémoire 10, on stocke un bit montrant par son état binaire, état zéro, que l'adresse stockée ne correspond à rien. La mémoire 10 comporte donc un plan mémoire 20 comportant 16 mots de 12 bits. Le plan mémoire 20 est en relation avec un circuit 21 de lecture et de programmation de cette mémoire 10.

Le principe de l'invention est le suivant. Au moment où on veut écrire un mot dans la mémoire 1, on mémorise dans des registres d'une mémoire dynamique d'une part ce mot, et d'autre part une adresse dans la mémoire 1 où ce mot doit être écrit. (Pour une opération d'effacement on ne mémoriserait que l'adresse d'effacement si par ailleurs l'automate était susceptible d'effectuer des effacement seuls). Puis on effectue ces opérations d'écriture (ou d'effacement). Une fois l'opération effectuée, on compare le contenu à l'adresse concernée de la mémoire 1 avec le mot mémorisé dans le registre dynamique. Si le contenu mémorisé est identique au contenu écrit dans la mémoire 1, l'opération de programmation ou d'effacement a été faite correctement. Si ce n'est pas le cas, on en déduit premièrement que la cellule mémoire ou le mot mémoire situés à l'adresse concernée est défectueux et que, deuxièmement, il faut réparer. Un tel procédé de vérification est déjà connu dans le domaine des EPROM.

Pour réparer on stocke l'adresse défectueuse dans la mémoire 10 par une opération de programmation de cette mémoire 10. Ensuite le circuit logique 11 interprète l'adresse nouvellement stockée en mémoire 10 pour adresser en correspondance une cellule ou un mot dans la ligne R129 de la mémoire 1. On écrit alors le contenu du mot à écrire dans un mot de cette ligne R129 dont l'adresse est maintenant décodée par le circuit 11. Dans un premier temps on retiendra que la mémoire 10 est du type non volatile, par exemple du même type que la mémoire 1. Eventuellement elle en constitue même une partie. Elle peut dans ce cas être écrite ou effacée avec les circuits 4 à 8 et 12 et 13 décrit jusqu'ici, ou par des circuits de ce type.

Lorsqu'on veut sélectionner un mot mémoire de la mémoire 1, on commence donc par comparer l'adresse de ce mot à sélectionner à chacune des adresses stockées dans la mémoire 10. On peut faire cette comparaison de deux manières. Soit on compare l'adresse désirée successivement à la première adresse stockée dans la mémoire 10, puis à la deuxième adresse stockée dans la mémoire 10 et ainsi de suite jusqu'à la dernière. Si cette comparaison ne révèle pas d'identité c'est qu'on a affaire à une adresse d'un mot, ou d'une cellule, de la mémoire 1 en bon état. Par contre, si c'est pas le cas, au moins une des comparaisons a révélé cette situation. Dans ce cas, conformément à ce qui a été évoqué ci-dessus, on produit un état logique B5 passant à l'état zéro au moment de cette révélation. Dans ce cas on peut arrêter la lecture de la mémoire 20 à l'endroit de l'adresse de la cellule mémoire détectée.

Dans une variante préférée on utilisera, pour le circuit de lecture écriture programmable 21, un circuit de lecture susceptible de lire simultanément toutes les cellules mémoires du plan mémoire 20. Cette lecture s'effectue au même moment que l'adresse défectueuse est envoyée aux décodeurs 12 et 13. Un tel circuit de lecture susceptible de lire les douze fois seize cellules du plan mémoire 20 est par exemple du type de celui décrit dans le brevet américain US-A-5 144 582 . Dans ce cas, les cellules mémoires de la mémoire 20 comportent des cellules mémoires de type dynamique organisées de telle façon qu'il n'est pas besoin d'amplificateur de lecture pour lire chacune de ces cellules. En effet les amplificateurs de lecture et les circuits associés sont, dans les circuits de lecture, des circuits qui occupent beaucoup de place. Ou encore le contenu de la mémoire non volatile est lu en entier au moment de la mise sous tension du circuit intégré et son contenu est stocké dans des bascules qui maintiennent en permanence en sortie des états binaires correspondants. Dans ce cas le plan mémoire 20 sera constitué d'un couple formé d'une mémoire non volatile et d'une telle mémoire dynamique ou de telles bascules à lecture simultanée de toutes les cellules.

A la mise sous tension d'un tel circuit, la mémoire dynamique est chargée avec le contenu de la mémoire non volatile associée. Un micro-contrôleur associé à la mémoire 10 assure le transfert à la mémoire dynamique, par lecture successive, de tous les mots de la mémoire non volatile. On retiendra cette solution dans la suite de la description, et on considérera que le circuit 21 est donc capable de délivrer d'un seul coup seize fois douze états logiques relatifs à la comparaison d'une adresse lue à chacune des seize adresses stockées dans la mémoire 10 (dans l'exemple chiffré). Quand une cellule mémoire du plan mémoire 1 aura été réparée, on rafraîchira le contenu des mémoires volatiles de la mémoire 20 par le nouveau contenu des mémoires non volatiles de cette mémoire. De cette façon, à tout moment, les mémoires volatiles renseigneront sur les cellules de la mémoire 1 qui sont réparées et dont les adresse sont déroutées.

En variante, un plan mémoire 20 avec des cellules de type non volatile classiques peut être mis en relation avec 12 x 16 amplificateurs de lecture/écriture/effacement.

Pour bien comprendre le fonctionnement de l'invention on considérera que dans la première ligne du plan mémoire 20 on a stocké une adresse dont les bits d'adresse sont A1' A2' etc... A11', et qu'en correspondance un bit A-12' a été porté à 1 mentionnant la mémorisation de cette adresse défectueuse. Dans la deuxième ligne on a stocké une deuxième adresse défectueuse dont les bits d'adresse on pour valeur A1", A2" jusqu'à A11", le bit A12" étant également porté à 1. La troisième ligne et les autres lignes ont des bits stockés dont le contenu est indifférent, sauf le douzième qui est à l'état zéro parce que ces lignes ne sont pas encore employées mais vont servir pour la réparation de futures pannes.

La figure 3 montre le circuit comparateur programmable de l'invention. En pratique ce circuit sera formé d'un circuit logique programmable de type dit PLA (Programmed Logic Array: circuit logique programmable), et qui aura été programmé en conséquence. La description qui est présentée ci-après ne fait que préciser comment, pour les besoin de l'invention, un tel circuit programmable va être programmé: comment vont être reliées ensemble les différentes fonctions électroniques qu'il est susceptible de mettre en oeuvre. Ce circuit comporte, au moins, dans le cas précis de la présente description, un jeu de seize fois onze portes logiques OU Exclusif (XOR) telles que 23 à 25. Chacune des portes OU Exclusif par exemple la porte 23, reçoit un bit de l'adresse défectueuse, par exemple A1, simultanément avec un bit de même poids lu dans une ligne de la mémoire 20 par exemple A1'. Une porte OU Exclusif compare donc la valeur du bit d'adresse A1 au bit A1' et délivre un signal à 1 si les deux bits d'adresse comparés sont identiques. Les portes OU Exclusif sont ainsi groupées par onze en seize groupes, et les groupes sont relatifs à chacune des adresses enregistrées dans le plan mémoire 20. Des portes OU Exclusif groupées ont leurs sorties reliées sur une porte ET à onze entrées. Cette porte ET est par exemple constituée sur la figure 3 par une mise en cascade de onze transistors 26 à 28 de type N reliés entre eux en série par drains et sources entre l'alimentation V_{cc} et la masse. Les entrées de la porte ET sont constituées par les grilles de commande des transistors 26-28. En outre un transistor supplémentaire 29 de type N est également monté en cascade avec les transistors 26 à 28. Il reçoit sur sa grille de commande le signal du douzième bit correspondant aux onze bits d'adresse. En pratique le transistor 29 reçoit le signal dit A12'. Autrement dit, si un groupe de onze bits correspond à une adresse effectivement défectueuse stockée dans la mémoire 10 la porte ET 26-28 est mise en service par le transistor 29, elle est neutralisée dans le cas contraire. La constitution de la porte ET 26-28 est en fait complète en reliant un noeud 30 de sortie située en amont de la cascade des transistors 26 à 28, relié par une résistance R à Vcc, à l'entrée d'un inverseur 31. Cette représentation avec transistor et résistance n'est présentée que pour montrer comment peut être réalisée la configuration. En pratique la connexion des transistors dépendra de la technologie retenue pour constituer le circuit PLA. Notamment certains circuits modernes de PLA ne comportent pas de résistances pour limiter les consommations électriques.

On appelle COM₁,... COMᵢ, ..., COM₁₆ le signal disponible à la sortie des inverseurs tel que 31 et relatifs aux comparaisons de l'adresse (A1-A11) à sélectionner dans la mémoire 1 à l'adresse lue (A1'-A11') dans la première ligne, la ième ligne, ou la 16ième ligne du plan mémoire 20. Dans le circuit 11 il y a donc seize groupes de porte OU Exclusif et de cascades de transistors 26 à 29 pour délivrer seize signaux COM1 à COM16. Le signal B5 est produit par une porte OU 32, à seize entrées recevant les signaux COM1 à COM16, en série avec un inverseur 33.

Dans quatre portes OU 34 à 37 à huit entrées on combine par huit les signaux COM1 à COM16 pour produire des signaux d'adresse de remplacement B1 à B4. Ainsi, dès que l'un quelconque des signaux COM1 à COM16 passe à l'état 1, la sortie de la porte 32 passe à l'état 1 et le signal B5 passe à l'état zéro. La duplication des seize cascades des portes OU Exclusif est en relation avec la lecture simultanée de toutes les cellules mémoires de la mémoire 20. La partie inférieure de la figure 3 montrant l'arrangement des portes OU convient cependant aux deux cas : au cas où on lit au fur et à mesure chacune des adresses stockées dans le plan mémoire 20, ou au cas où on les lit toutes simultanément.

La porte logique 34 de type OU reçoit sur ses huit entrées des signaux COM1 à COM8. Le signal B1 en sortie de la porte 34 passe à l'état 1 si un quelconque de ces signaux COM1 à COM8 est à l'état 1. Les portes 35 et 36 et 37 reçoivent par exemple respectivement des signaux COM1, COM2 COM3, COM4, COM9, COM10, COM11, COM12, et COM1 COM2, COM5, COM6, COM9, COM10, COM13, COM 14 et COM1, COM3, COM5, COM7, COM9, COM11, COM13, COM15. De ce fait ces portes 34 à 37, interprètent différemment les états binaires des signaux COMi pour constituer des nouveaux bits d'adresse B1 à B4.

Au cas où on retiendrait la première variante, utile principalement quand la mémoire 1 est du type EEPROM série (dans ce cas on a du temps pour lire chacune des lignes du plan mémoire 20), les signaux COM1 à COM16 seraient progressivement stockés dans des bascules du même type que les bascules 16 à 17 à chaque fois qu'une ligne différente du plan mémoire 20 aurait été lue. Par la suite le fonctionnement de l'ensemble des portes OU 32 et 34 à 37 serait le même, validé par une fin de lecture de la mémoire 10.

Les figures 4a et 4b montrent un exemple de réalisation d'une porte OU Exclusif 23. Cette porte OU Exclusif 23 comporte deux portes ET 38 et 39 à deux entrées. La porte ET 38 reçoit sur ses entrées respectivement les signaux A1 et A'1. La porte 39 reçoit sur ses entrées les signaux complémentaires NA1 et NAl'. Les sorties des portes ET 38 et 39 sont reliées aux entrées d'une porte 40 OU à deux entrées. La sortie de la porte 40 constitue la sortie de la porte OU Exclusif. En pratique la sortie de la porte 40 est à l'état 1 si le bit d'adresse A1 est identique au bit d'adresse A'1, quelles que soient les valeurs de ces bits. La sortie 40 est à zéro si le bit A1 est d'un type opposé au bit A1'.

La figure 4b montre une réalisation symbolique du circuit représenté sur la figure 4a. La porte ET 38 est réalisée par la mise en cascade de deux transistors de type N 41 et 42 avec une résistance 43 entre l'alimentation V_{cc} et la masse. Le signal disponible entre la résistance 43 et le transistor 41 est appliqué sur une entrée de commande d'un transistor 44 inverseur raccordé par une résistance 45 à l'alimentation V_{cc} et par son autre borne à la masse. Un montage similaire est effectué pour la porte 39 recevant les signaux NA1, directement, et le signal A1' inversé dans un inverseur comportant un transistor 46 et une résistance 47. Les sorties des deux portes ET sont appliquées sur une porte OU à deux entrées. Celle-ci est formée par deux transistors en parallèle 48 et 49 montés entre la masse et une borne d'une résistance 50 reliée par ailleurs à l'alimentation Vcc. La porte OU comporte enfin un inverseur muni d'un transistor 51 et d'une résistance 52 pour redresser la polarité du signal.

Le fonctionnement du circuit est le suivant (Figure 1). Lorsqu'une adresse est envoyée aux décodeurs 12 ou 13, elle est en même temps envoyée au circuit logique programmable 9. Celui-ci provoque alors immédiatement la lecture de toutes les lignes du plan mémoire 20 simultanément. Les bits d'adresse stockés dans le plan mémoire 20 sont alors comparés dans le circuit comparateur 11 (figure 3) aux bits d'adresse du mot mémoire à sélectionner dans la mémoire 1. Si le mot ou la cellule mémoire à sélectionner est en bon état, le signal B5 reste à l'état 1, le circuit de redondance dynamique est inhibé. Par contre, si une des lignes de la mémoire 10 possède en mémorisation des bits d'adresse identiques à ceux de l'adresse à sélectionner, un groupement de portes OU Exclusif (de type 23 à 25) correspondant permet de disposer d'un signal COMi à l'état 1, les autres signaux COM étant à l'état zéro. Le circuit logique 11 délivre alors d'une part un signal B5 à l'état zéro, et d'autre part des bits d'adresse B1 à B4 correspondant à une adresse de remplacement.

Le changement de polarité du signal B5 d'une part sélectionne la ligne R129 dans la mémoire 1 (en inhibant les autres lignes), et d'autre part remplace en entrée du décodeur 13 les signaux A8-A11 par les signaux B1-B4 au moyen des couples de transistors de commutation 18-19. Le fonctionnement est donc simple. La mémoire 10 est le seul élément qui renseigne sur les adresses défectueuses, les autres circuits sont figés. Ils n'ont pas besoin d'être modifiés. Cette mémoire 10 est munie, d'une manière connue, de ses circuits de lecture 21 et de son décodeur d'accès 22 Le décodeur d'accès 22 n'est utilisé, dans le cas où on lit toute la mémoire simultanément, que pour accéder à une ligne particulière de cette mémoire en vue de la programmer lorsque l'on a détecté l'apparition d'une nouvelle adresse défectueuse dans la mémoire 1.

L'ensemble ainsi décrit est particulièrement simple. On notera en effet que l'ensemble des transistors 26 à 29 constitue des portes ET alors que les portes logiques 32 et 34 à 37 sont des portes OU. Ces portes ET et ces portes OU peuvent être réalisées notamment sous la forme d'un circuit de type PLA comportant un plan de portes ET et un plan de portes OU. En outre dans un tel circuit PLA, le plan des portes ET est relié au plan des portes OU par des connexions elles mêmes programmables. Ainsi les portes 38 et 39 font partie du plan des portes ET alors que la porte 40 fait partie du plan de porte OU. L'ensemble 38-40 constitue donc une porte OU Exclusif. La sortie de la porte 40 peut à son tour être connectée à une entrée du plan des portes ET. Les sorties des portes telles que 40 sont ainsi reliées à des portes ET qui jouent des rôles tels que celui de la porte ET 26-30. Les sorties de ces portes ET peuvent être connectées à des entrées de portes OU du circuit PLA. Autrement dit un tel circuit peut tout faire. Cependant on peut éviter le rebouclage de la sortie des portes OU Exclusif en sortie du circuit PLA sur des entrées de circuit PLA en remarquant qu'il s'agit là d'effectuer une fonction logique qui, par factorisation, peut toujours se mettre sous la forme booléenne d'unions d'intersections. On peut alors directement utiliser successivement le plan des portes ET et des portes OU.

Lorsque toutes les cellules mémoires de la mémoire 10 sont lues simultanément (circuit le plus complexe tel que décrit), le circuit de redondance de l'invention peut être utilisé pour des mémoires de type EEPROM à accès parallèle. En effet on constate que l'accès à la ligne R 129 et, dans celle-ci, à la cellule ou un mot de remplacement est simultané à l'adressage de la cellule défectueuse. Il est immédiat. Par contre s'agissant de mémoires EEPROM à accès série pour lesquelles le temps d'accès n'est pas contraignant on pourra provoquer une lecture successive de chacune des lignes de la mémoire 10 et s'arrêter dès que la comparaison aura été révélatrice de la détection d'une adresse défectueuse.

## Revendications

1. Mémoire (1) en circuit intégré non volatile, programmable et effaçable électriquement, comportant des mots mémoires, chaque cellule (2) mémoire d'un mot mémoire étant munie d'un transistor à grille flottante et un circuit logique programmable dynamiquement muni :
- d'une mémoire auxiliaire (10) non volatile pour mémoriser des adresses de mots mémoires défectueux, et
- d'un circuit (14-19) de réadressage pour sélectionner, en remplacement, un autre mot de cette mémoire,
la mémoire (1) étant caractérisée en ce que ledit circuit logique programmable dynamiquement est également muni d'un circuit (11) de comparaison d'une adresse de sélection d'un mot mémoire à une adresse mémorisée dans la mémoire auxiliaire et en ce que le circuit de comparaison (11) comporte, en sortie, un jeu (32-35) de portes OU connectées, en entrée, à un jeu (26-29) de portes ET, elles mêmes connectées, en entrée, à un comparateur (23-25), la mémoire auxiliaire étant reliée à ce comparateur, ledit comparateur étant destiné à comparer simultanément ladite adresse de sélection d'un mot mémoire aux adresses de mots mémoires défectueux, ledit jeu de portes OU délivrant pour ledit circuit de réadressage (14-19) un signal de commande (B5) permettant d'invalider le décodage des bits d'adresse correspondant aux mots mémoires défectueux, ainsi qu'un nombre prédéterminé de bits d'adresse de substitution (B1-B4).

2. Mémoire selon la revendication 1, caractérisée en ce qu'elle est organisée en 2^{M} fois 2^{N} mots mémoires, accessibles individuellement, par respectivement, un premier décodeur (12) d'adresse recevant M bits d'adresse et un deuxième décodeur (13) d'adresse recevant N bits d'adresse, N étant supérieur ou égal à 2, en ce qu'elle comporte à titre de remplacement 2^{N} mots supplémentaires (R129) reliés au premier (12) et au deuxième décodeur (13), ces 2^{N} mots supplémentaires correspondant à 2^{N} adresses de M + N bits mémorisées dans la mémoire auxiliaire (10), le circuit de réadressage comportant un jeu de transistors (14, 15, 18, 19) recevant ledit signal de commande (B5) pour invalider le décodage des M+N bits d'adresse, valider un accès au 2^{N} mots supplémentaires, et substituer au décodage des M+N bits d'adresse (A8-A11), ledit nombre prédéterminé N de bits d'adresse (B1-B4) issus du circuit logique programmable.

3. Mémoire selon l'une des revendications 1 à 2, caractérisée en ce qu'elle est organisée en 2^{M} fois 2^{N} mots mémoires, accessibles individuellement, par respectivement, un premier décodeur (12) d'adresse recevant M bits d'adresse et un deuxième décodeur (13) d'adresse recevant N bits d'adresses, N étant supérieur ou égal à 2, en ce qu'elle comporte à titre de remplacement 2^{N} mots supplémentaires (R129) reliés au deuxième décodeur (13), ces 2^{N} mots supplémentaires correspondant à 2^{N} adresses de M+N bits mémorisées dans la mémoire auxiliaire (10), le circuit de réadressage comportant un jeu de transistors (14, 15, 18, 19) recevant ledit signal de commande (B5) pour invalider le décodage des N bits d'adresse, valider un accès aux 2^{N} mots supplémentaires, et substituer au décodage des N bits d'adresse (A8-A11) ledit nombre prédéterminé N de bits d'adresse (B1-B4) issus du circuit logique programmable, le jeu des portes ET du circuit logique programmable comportant 2^{N} portes ET avec M+N entrées chacune, le jeu des portes OU du circuit logique programmable comportant (2^{N})/4 portes OU à (2^{N})/2 entrées à chacune, et une porte OU à 2^{N} entrées dont la sortie délivre le signal de commande (B5).

4. Mémoire selon l'une des revendication 2 à 3, caractérisée en ce qu'elle comporte un circuit (21) pour lire successivement toutes les adresses mémorisées dans la mémoire auxiliaire.

5. Mémoire selon l'une des revendications 2 à 4, caractérisée en ce que la mémoire auxiliaire comporte 2^{N}x(M+N) circuits (21) de lecture pour lire simultanément les 2^{N} adresses mémorisées et les adresser ensemble au circuit comparateur, afin de décoder l'adresse de redondance durant un même cycle de lecture.

6. Mémoire selon l'une des revendications 2 à 5, caractérisée en ce que la mémoire auxiliaire comporte 2^{N}x(M+N) bascules pour mémoriser en permanence des états binaires correspondant aux adresses défectueuses à réparer.

7. Mémoire selon l'une des revendications 1 à 6, caractérisée en ce que le circuit comparateur comporte, pour chaque bit d'adresse sélectionnée et pour chaque bit d'adresse mémorisée, une porte OU Exclusif (23).

8. Mémoire selon la revendication 7, caractérisée en ce que la porte OU Exclusif comporte une première porte ET (38) reliée en entrée à un circuit délivrant ce bit d'adresse (A₁) et à une des sorties (A'₁) de la mémoire auxiliaire, une deuxième porte ET (39) reliée en entrée à un circuit délivrant l'inverse de ce bit d'adresse (NA1) et à un circuit d'inversion relié à la même sortie de la mémoire auxiliaire, et une porte OU (46) reliée, en entrée, aux sorties de ces deux portes ET.

9. Mémoire selon l'une des revendications 1 à 8, caractérisée en ce que le circuit comparateur comporte un circuit de type PLA muni d'un plan de portes ET relié à un plan de portes OU.

## Patentansprüche

1. Nichtflüchtiger, integrierter Speicher (1), elektrisch programmierbar und löschbar, umfassend Speicherworte, wobei jede Speicherzelle (2) eines Speicherworts mit einem Transistor mit schwebendem Gate versehen ist, und eine dynamisch programmierbare Logikschaltung, die
- einen nichtflüchtigen Hilfsspeicher (10) zum Speichern von Adressen defekter Speicherworte und
- eine Umadressierschaltung (14-19) zum ersatzweisen Auswählen eines anderen Speicherworts dieses Speichers aufweist,
wobei der Speicher (1) dadurch gekennzeichnet ist, daß die dynamisch programmierbare Logikschaltung außerdem eine Schaltung (11) zum Vergleich einer Speicherwort-Auswahladresse mit einer in dem Hilfsspeicher gespeicherten Adresse aufweist, und daß die Vergleichsschaltung (11) ausgangsseitig einen Satz (32-35) von ODER-Toren umfaßt, die eingangsseitig mit einem Satz (26-29) von UND-Toren verbunden sind, welche selbst wiederum eingangsseitig mit einem Vergleicher (23-25) verbunden sind, wobei der Hilfsspeicher an diesen Vergleicher angeschlossen ist, der Vergleicher dazu bestimmt ist, simultan die Speicherwort-Auswahladresse mit den Adressen defekter Speicherworte zu vergleichen, und der Satz von ODER-Toren für die Umadressierschaltung (14-19) ein Steuersignal (B5), welches erlaubt, die Decodierung von den defekten Speicherworten entsprechenden Adreßbit zu sperren, sowie eine vorbestimmte Anzahl von Substitutionsadreßbits (B1-B4) ausgibt.

2. Speicher nach Anspruch 1, dadurch gekennzeichnet, daß er in 2^{M} mal 2^{N} Speicherworten organisiert ist, auf die mittels jeweils eines ersten Adreßdecoders (12), der M Adreßbit empfängt, und eines zweiten Adreßdecoders (13), der N Adreßbit empfängt, wobei N größer oder gleich 2 ist, einzeln zugegriffen werden kann, und daß er als Ersatz 2^{N} zusätzliche, mit dem ersten (12) und dem zweiten (13) Decoder verbundene Worte (R129) umfaßt, wobei diese zusätzlichen 2^{N} Worte 2^{N} Adressen von M+N in dem Hilfsspeicher (10) gespeicherten Bit entsprechen, und wobei die Umadressierschaltung einen Satz von Transistoren (14, 15, 18, 19) umfaßt, der das Steuersignal (B5) empfängt, um die Decodierung der M+N Adreßbit zu sperren, einen Zugriff auf die 2^{N} zusätzlichen Worte freizugeben und bei der Decodierung der M+N Adreßbit (A8-A11) die durch die programmierbare Logikschaltung ausgegebene, vorbestimmte Anzahl N von Adreßbit (B1-B4) zu ersetzen.

3. Speicher nach einem der Ansprüche 1 bis 2, dadurch gekennzeichnet, daß er in 2^{M} mal 2^{N} Speicherworten organisiert ist, auf die mittels jeweils eines ersten Adreßdecoders (12), der M Adreßbit empfängt, und eines zweiten Adreßdecoders (13), der N Adreßbit empfängt, wobei N größer oder gleich 2 ist, einzeln zugegriffen werden kann, und daß er als Ersatz 2^{N} zusätzliche, mit dem zweiten (13) Decoder verbundene Worte (R129) umfaßt, wobei diese zusätzlichen 2^{N} Worte 2^{N} Adressen von M+N in dem Hilfsspeicher (10) gespeicherten Bit entsprechen, die Umadressierschaltung einen Satz von Transistoren (14, 15, 18, 19) umfaßt, der das Steuersignal (B5) empfängt, um die Decodierung der M+N Adreßbit zu sperren, einen Zugriff auf die 2^{N} zusätzlichen Worte freizugeben und bei der Decodierung der M+N Adreßbit (A8-A11) die durch die programmierbare Logikschaltung ausgegebene, vorbestimmte Anzahl N von Adreßbit (B1-B4) zu ersetzen, der Satz von UND-Toren der programmierbaren Logikschaltung 2^{N} UND-Tore mit jeweils M+N Eingängen umfaßt, und der Satz von ODER-Toren der programmierbaren Logikschaltung (2^{N})/4 ODER-Tore mit jeweils (2^{N})/2 Eingängen umfaßt sowie ein ODER-Tor mit 2^{N} Eingängen, dessen Ausgang das Steuersignal (B5) abgibt.

4. Speicher nach einem der Ansprüche 2 oder 3, gekennzeichnet durch eine Schaltung (21) zum sukzessiven Lesen aller der in dem Hilfsspeicher gespeicherten Adressen.

5. Speicher nach einem der Ansprüche 2 bis 4, dadurch gekennzeichnet, daß der Hilfsspeicher 2^{N}x(M+N) Leseschaltungen (21) umfaßt zum simultanen Lesen der 2^{N} gespeicherten Adressen und der mit der Vergleicherschaltung gemeinsamen Adressen, um die Redundanzandresse während ein und demselben Lesezyklus zu decodieren.

6. Speicher nach einem der Ansprüche 2 bis 5, dadurch gekennzeichnet, daß der Hilfsspeicher 2^{N}x(M+N) Kippglieder umfaßt zum dauerhaften Speichern von den zu reparierenden Defektadressen entsprechenden binären Zuständen.

7. Speicher nach einem der Ansprüche 1 bis 6, dadurch gekennzeichnet, daß die Vergleicherschaltung für jedes Bit einer ausgewähltes Adresse und für jedes Bit einer gespeicherten Adresse ein Exklusiv-ODER-Tor (23) umfaßt.

8. Speicher nach Anspruch 7, dadurch gekennzeichnet, daß das Exklusiv-ODER-Tor ein erstes UND-Tor (38), welches eingangsseitig mit einer Schaltung, die dieses Adreßbit (A₁) liefert, sowie mit einem der Ausgänge (A'₁) des Hilfsspeichers verbunden ist, ein zweites UND-Tor (39), welches eingangsseitig mit einer Schaltung, die das Inverse dieses Addreßbits (NA1) liefert, sowie mit einer mit demselben Ausgang des Hilfsspeichers verbundenen Umkehrschaltung verbunden ist, und ein ODER-Tor (46), welches eingangsseitig mit den Ausgängen dieser beiden UND-Tore verbunden ist, umfaßt.

9. Speicher nach einem der Ansprüche 1 bis 8, dadurch gekennzeichnet, daß die Vergleicherschaltung eine ein Feld von UND-Toren, die mit einem Feld von ODER-Toren verbunden sind, aufweisende PLA-Schaltung umfaßt.

## Claims

1. Electrically programmable and erasable non-volatile integrated circuit memory (1), having memory words, each memory cell (2) of a memory word being provided with a floating-gate transistor and a dynamically programmable logic circuit, provided with:
- a non-volatile auxiliary memory (10) for storing to memory addresses of defective memory words, and
- a re-addressing circuit (14-19) for selecting as a replacement another word from this memory,
the memory (1) being characterised in that the said dynamically programmable logic circuit is also provided with a circuit (11) for comparing a memory word selection address with an address stored in the auxiliary memory and in that the comparison circuit (11) has at its output a set (32-35) of OR gates connected at the input to a set (26-29) of AND gates, these in turn connected at their input to a comparator (23-25), the auxiliary memory being connected to this comparator, the said comparator being designed to compare simultaneously the said memory word selection address with the addresses of defective memory words, the said set of OR gates delivering for the said re-addressing circuit (14-19) a control signal (B5) for invalidating the decoding of the address bits corresponding to the defective memory words, and a predetermined number of substitution address bits (B1-B4).

2. Memory according to Claim 1, characterised in that it is organised into 2^{M} times 2^{N} memory words, individually accessible, by means of, respectively, a first address decoder (12) receiving M address bits and a second address decoder (13) receiving N address bits, N being greater than or equal to 2, in that it has by way of replacement 2^{N} additional words (R129) connected to the first (12) and second (13) decoders, these 2^{N} additional words corresponding to 2^{N} addresses of M + N bits stored in the auxiliary memory (10), the re-addressing circuit having a set of transistors (14, 15, 18, 19) receiving the said control signal (B5) for invalidating the decoding of the M+N address bits, validating access to 2^{N} additional words, and substituting for the decoding of the M+N address bits (A8-A11) the said predetermined number N of address bits (B1-B4) coming from the programmable logic circuit.

3. Memory according to one of Claims 1 to 2, characterised in that it is organised into 2^{M} times 2^{N} memory words, individually accessible, by means of, respectively, a first address decoder (12) receiving M address bits and a second address decoder ((13) receiving N address bits, N being greater than or equal to 2, in that it has by way of replacement 2^{N} additional words (R129) connected to the second decoder (13), these 2^{N} additional words corresponding to 2^{N} addresses of M+N bits stored in the auxiliary memory (10), the re-addressing circuit having a set of transistors (14, 15, 18, 19) receiving the said control signal (B5) for invalidating the decoding of the N address bits, validating access to the 2^{N} additional words and substituting for the decoding of the N address bits (A8-A11) the said predetermined number N of address bits (B1-B4) coming from the programmable logic circuit, the set of AND gates of the programmable logic circuit having 2^{N} AND gates with M+N inputs each, the set of OR gates of the programmable logic circuit having (2^{N})/4 OR gates with (2^{N})/2 inputs each, and one OR gate with 2^{N} inputs, whose output delivers the control signal (B5).

4. Memory according to one of Claims 2 to 3, characterised in that it has a circuit (21) for reading successively all the addresses stored in the auxiliary memory.

5. Memory according to one of Claims 2 to 4, characterised in that the auxiliary memory has 2^{N}x(M+N) read circuits (21) for reading simultaneously the 2^{N} stored addresses and sending them together to the comparator circuit in order to decode the redundant address during one and the same read cycle.

6. Memory according to one of Claims 2 to 5, characterised in that the auxiliary memory has 2^{N}x(M+N) flip-flops for permanently storing to memory binary states corresponding to the defective addresses to be repaired.

7. Memory according to one of Claims 1 to 6, characterised in that the comparator circuit has, for each selected address bit and for each stored address bit, an exclusive-OR gate (23).

8. Memory according to Claim 7, characterised in that the exclusive-OR gate has a first AND gate (38) connected at the input to a circuit delivering this address bit (A₁) and to one of the outputs (A'₁) of the auxiliary memory, a second AND gate (39) connected at the input to a circuit delivering the inverse of this address bit (NA1) and to an inverting circuit connected to the same output of the auxiliary memory, and an OR gate (46) connected, at the input, to the outputs of these two AND gates.

9. Memory according to one of Claims 1 to 8, characterised in that the comparator circuit has a PLA type circuit provided with an AND gate plane connected to an OR gate plane.
